# EUROPEAN PATENT SPECIFICATION

(11) **EP 3 622 616 B1**
(45) Date of publication and mention of the grant of the patent: **02.12.2026**
(21) Application number: 18720202.3
(22) Date of filing: 20.04.2018
(51) Int. Cl.: H02M 1/00, G01D 5/249, H02P 8/34, G05D 1/00

(54) **SERVO DRIVER**
SERVOSTEUERUNG
SERVOCOMMANDE

(30) Priority: 08.05.2017 CN 201710317916
(43) Date of publication of application: 18.03.2020
(73) Proprietor: Siemens Aktiengesellschaft, 80333 München (DE)
(72) Inventor: HAN, Ying, Nanjing 211100 (CN); WU, Jian Yuan, Nanjing 210000 (CN)
(74) Representative: Isarpatent
(86) International application number: PCT/EP2018/060147
(87) International publication number: WO 2018/206266

(56) References cited:
- CN-A- 104 925 600
- CN-A- 106 547 291
- CN-B- 103 389 684
- CN-Y- 2 768 055
- JP-A- H08 247 788
- TW-A- 201 338 944
- US-A1- 2006 271 251
- US-A1- 2015 069 948
- US-B1- 6 191 543
- DELTA SERVODRIVE: "Manualslib.com -Simplified Manuals Manuals / Brands / Delta Manuals / Servo Drives / ASDA-B2-F Series / User manual / PDF DELTA ASDA-B2-F SERIES SERVO DRIVE USER MANUAL", 1 September 2015 (2015-09-01), XP093413911, Retrieved from the Internet <URL:https://downloadcenter.deltaww.com/en-US/DownloadCenter?v=1&CID=06&itemID=060201&downloadID=B2%20Series&dataType=9&sort_expr=cdate&sort_dir=DESC>

## Description

### Technical Field

The present invention relates to a servo driver, and in particular to a servo driver which is capable of realizing the switching of a pulse type to adapt to various upper computers or PLCs.

### Background Art

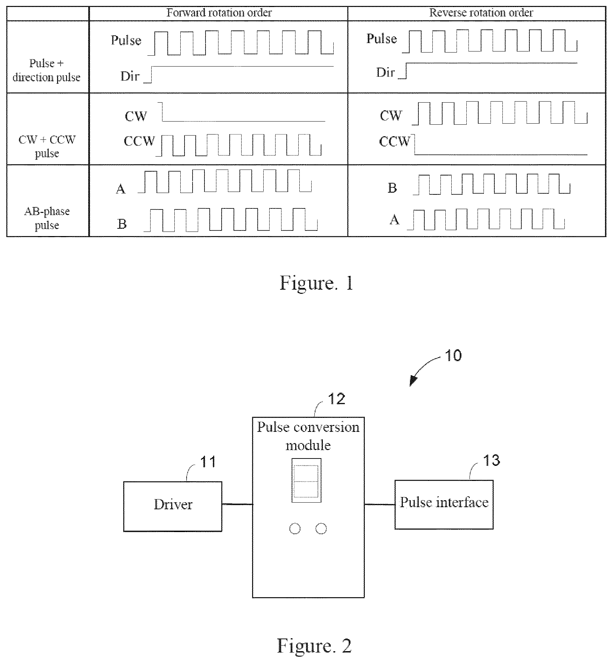

When pulse control is used, the pulse receiving mode for a servo driver can be divided into three types: clockwise and counter-clockwise pulse control (CW+CCW), pulse plus direction control (pulse + direction) and AB-phase input control (also referred to as phase difference control, which is common in handwheel control), and the waveform diagrams of these three pulse forms are different from one another, for example, as shown in Fig. 1.

In general, at present, many upper computers or PLCs can only provide a pulse plus direction output mode; however, the pulse plus direction output mode has a relatively poor anti-interference performance. In addition, servo drivers in the prior art generally cannot switch the pulse mode. Therefore, the driver and the upper computer/PLC in the prior art are limited in terms of type-selection matching or function implementation. If a pulse signal of an upper computer or a PLC cannot match that of a servo driver, at present, only the type selection of the servo driver can be abandoned, or the use of the function thereof may be limited.

US2015069948 discloses a servo driver with a pulse format converter. Seven-segment displays are described, for example, in CN104925600 and in the "DELTA ASDA-B2-F SERIES SERVO DRIVE USER MANUAL".

### Summary of the Invention

With regard to the problems in the prior art, the embodiments of the present invention provide a novel servo driver. The servo driver can convert the type of a pulse signal, so as to solve many problems caused by mismatching of the pulse signal type.

Specifically, the present invention provides a servo driver, according to claim 1, comprising: a driver, a pulse conversion module and a pulse interface, wherein the pulse conversion module is connected between the pulse interface and the driver, and the pulse conversion module converts the type of a pulse control signal received by the pulse interface, and then outputs same to the driver, with the type of the pulse control signal comprising at least one of a clockwise and counter-clockwise pulse control type, a pulse plus direction control type and an AB-phase input control type. The servo driver of the present invention can use a pulse conversion module to convert the type of a pulse from an upper computer or a PLC, so as to solve the limitations where the type selection of the driver or the upper computer/PLC cannot be performed or the function thereof cannot be used due to the mismatching of the pulse signal type.

According to one embodiment of the present invention, in the servo driver, the pulse conversion module comprises a complex programmable logic device, and pulse conversion logic for realizing the conversion between different pulse control system signal types is provided in the complex programmable logic device. The complex programmable logic device can be used for parallel processing, so as to eliminate the problem of time delays.

According to one embodiment of the present invention, in the servo driver, the pulse conversion module further comprises a display and a button which are in signal connection with the complex programmable logic device, wherein a user switches between various types of conversion modes via the button, and the display at least displays a conversion mode which is currently implemented by the pulse conversion module, so as to facilitate the user in operating and selecting a conversion mode for the pulse control signal.

According to one embodiment of the present invention, in the servo driver, the display is a 1-bit digital display, and different numbers displayed on the display represent different conversion modes.

According to one embodiment of the present invention, in the servo driver, the pulse conversion module comprises two buttons, and the two buttons respectively realize the operations of adding one to and subtracting one from a number on the 1-bit digital display when being pressed down, so as to switch the conversion mode by means of either of the two buttons.

According to one embodiment of the present invention, in the servo driver, the pulse conversion module further comprises a first transceiver and a second transceiver which are in signal connection with the complex programmable logic device, wherein the first transceiver is in signal connection with the driver, and the second transceiver is in signal connection with the pulse interface. In this way, the pulse conversion module can be provided outside the driver, for example, on a cabinet, and the two are connected wirelessly.

According to one embodiment of the present invention, in the servo driver, the pulse conversion module is provided on a housing of the servo driver or is provided outside a cabinet accommodating the servo driver, so as to expose the display and the buttons.

It should be appreciated that the above-mentioned general description and the following detailed description of the present invention are all exemplary and illustrative, and are intended to provide further explanations for the present invention as claimed in the claims.

### Brief Description of the Drawings

The accompanying drawings are included to provide further understanding of the present invention and are incorporated in and constitute a part of the present application, show the embodiments of the present invention, and serve, together with the description, to explain the principles of the present invention. In the accompanying drawings:
Fig. 1 exemplarily shows the pulse forms of three types of pulse control signals.
Fig. 2 shows a schematic structure of a servo driver according to the present invention.
Fig. 3 shows one embodiment of a pulse conversion module according to the present invention.
Fig. 4 shows one embodiment of a pulse conversion mode.

### Description of Reference Signs:

- 10: Servo driver
- 11: Driver
- 12: Pulse conversion module
- 13: Pulse interface
- 14: Complex programmable logic device
- 15: Display
- 16: Button
- 17: First transceiver
- 18: Second transceiver

### Detailed Description of Embodiments

The embodiments of the present invention will now be described with detailed reference to the drawings. Detailed reference will now be made to the preferred embodiments of the present invention, and the examples thereof are shown in the accompanying drawings. Wherever possible, the same or similar parts will be denoted by using the same reference signs in all the accompanying drawings. In addition, although the terms used in the present invention are selected from common general terms, some terms mentioned in the description of the present invention may be selected by the applicant at his or her discretion, and the detailed meanings thereof are explained in the relevant part of the description of the present invention. In addition, the present invention should be understood not only by the terms actually used, but also by the meaning contained in each term.

Firstly, with reference to Fig. 2, the servo driver 10 of the present invention mainly comprises: a driver 11, a pulse conversion module 12 and a pulse interface 13. The pulse conversion module 12 is connected between the driver 11 and the pulse interface 13, wherein the pulse conversion module 12 converts the type of a pulse control signal received by the pulse interface 13, and then outputs same to the driver 11. The type of the pulse control signal comprises at least one of a clockwise and counter-clockwise pulse control type (CW+CCW), a pulse plus direction control type (pulse + direction) and an AB-phase input control type (also referred to as phase difference control). Therefore, the servo driver 10 of the present invention may use the pulse conversion module 12 to convert the type of a pulse from an upper computer or a PLC, so as to solve the limitations where the type selection of the driver or the upper computer/PLC cannot be performed or the functions thereof cannot be used due to the mismatching of the pulse signal type. In addition, as mentioned above, any form of conversion between pulse types can also improve the anti-interference performance of the servo driver 10, thereby avoiding a pulse loss or increase caused by pulse mismatching. The pulse conversion module 12 may be a small-sized module with a small volume, so as to be conveniently configured on the servo driver 10 or provided on a cabinet accommodating the servo driver 10.

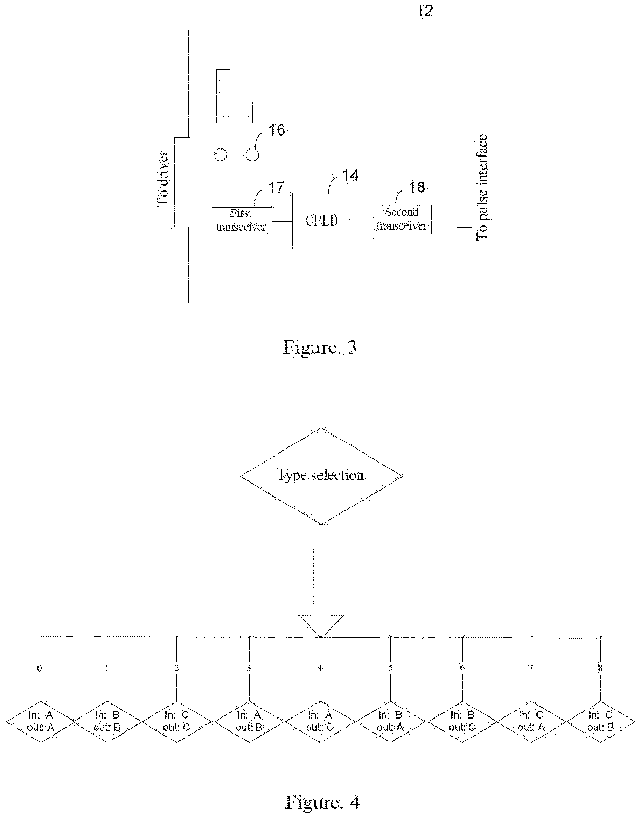

Fig. 3 shows one embodiment of the pulse conversion module 12 according to the present invention. As shown in Fig. 3, the pulse conversion module 12 further comprises a complex programmable logic device (CPLD) 14, a display 15, buttons 16, a first transceiver 17 and a second transceiver 18. The complex programmable logic device 14 performs parallel processing, so as to eliminate the problem of time delays. In addition, the use of the complex programmable logic device 14 also has the advantages of a low cost and clear logic, etc.

A pulse conversion logic for realizing the conversion between different pulse control system signal types may be provided in the complex programmable logic device 14. For example, the pulse conversion logic may be hardware in the form of a semiconductor device, and may also be a data structure, a mapping table, a code, etc., in the form of a conversion table stored in a memory in the complex programmable logic device 14. When in operation, the pulse conversion logic may convert a pulse control signal (being of a clockwise and counter-clockwise pulse control type in this example) from the pulse interface 13 according to a conversion method (for example, converting same from a clockwise and counter-clockwise pulse control type into a pulse plus direction control type) selected by a user, and output the converted pulse control signal (being of a pulse plus direction control type in this example).

According to one embodiment of the present invention, the pulse conversion module 12 may be a separate device further comprising the display 15 and the button 16 which are in signal connection with the complex programmable logic device 14. The volume of the device may be so small that it can be conveniently provided on a housing of the servo driver 10 or provided outside a cabinet accommodating the servo driver 10, so as to expose the display 15 and the buttons 16. In this embodiment, a user can switch between various types of conversion modes by means of the button 16, while the display 15 at least displays a conversion mode which is currently implemented by the pulse conversion module 12. In addition, the display 15 may be a 1-bit digital display, and different numbers displayed on the display 15 represent different conversion modes.

For example, the 1-bit digital display can at least display the numbers 0 to 8, wherein each of the numbers corresponds to one conversion mode. With reference to Fig. 4, after type selection is performed (via the button 16), each number displayed on the 1-bit digital display 15 corresponds to one conversion method. In Fig. 4, as an example, "A" represents the clockwise and counter-clockwise pulse control type (CW+CCW), "B" represents the pulse plus direction control type (pulse + direction), and "C" represents the AB-phase input control type (also referred to as phase difference control). Thus, according to Fig. 4, the number 0 (the number being displayed by the 1-digit digital display 15) represents a conversion mode where an input and an output are both of the clockwise and counter-clockwise pulse control type (CW+CCW), and the number 4 represents a conversion mode where the input is of the clockwise and counter-clockwise pulse control type (CW+CCW) and the output is of the AB-phase input control type. Therefore, the nine numbers 0-8 can represent all the conversion modes between every two of the three control types. Therefore, as long as a user correctly selects, during use, one conversion mode by firstly using the button 16, an upper computer/PLC and a driver of any pulse type can be used for connection, so as to achieve the compatibility between the upper computer/PLC and drivers of different pulse types.

In the embodiment shown in Fig. 3, the pulse conversion module 12 uses two buttons 16. For example, the two buttons 16 respectively realize the operations of adding one to and subtracting one from a number on the 1-bit digital display when being pressed down, so as to switch the conversion mode by means of either of the two buttons. In another embodiment, the pulse conversion module 12 may also achieve a similar function by only using a single button 16 that performs an operation of adding one (or subtracting one).

In addition, in an embodiment where the pulse conversion module 12 is provided outside a cabinet accommodating the servo driver 10, the pulse conversion module 12 may further comprise a first transceiver 17 and a second transceiver 18 which are in signal connection with the complex programmable logic device 14, wherein the first transceiver 17 is in signal connection with the driver 11, and the second transceiver 18 is in signal connection with the pulse interface 13.

In summary, the servo driver of the present invention can convert the three pulse forms arbitrarily, and a customer can convert, according to requirements during use, a pulse form into a type that can be identified or can be expected to be used. Therefore, the present invention can solve the limitations where the type selection of a driver or an upper computer/PLC cannot be performed or the function thereof cannot be used due to the mismatching of the pulse signal type. In addition, any form of conversion between pulse types can also improve the anti-interference performance of the servo driver, thereby avoiding a pulse loss or increase caused by pulse mismatching.

The invention is defined by the appended claims.

## Claims

1. A servo driver (10) comprising:
a driver (11),
a pulse conversion module (12) and
a pulse interface (13),
wherein the pulse conversion module (12) is connected between the pulse interface (13) and the driver (11), and the pulse conversion module (12) converts the type of a pulse control signal received by the pulse interface (13) and then outputs same to the driver (11), with the type of the pulse control signal comprising at least one of a clockwise and counter-clockwise pulse control type, a pulse plus direction control type and an AB-phase input control type,
wherein the pulse conversion module (12) comprises a complex programmable logic device (14), and pulse conversion logic for realizing the conversion between different pulse control system signal types is provided in the complex programmable logic device (14) and wherein the complex programmable logic device is configured for parallel processing, and
wherein the pulse conversion module (12) comprises a display (15) and two buttons (16) which are in signal connection with the complex programmable logic device (14), wherein the pulse conversion module (12) is a separate device provided on a housing of the servo driver (10) so as to expose the display (16) and the two buttons (16),
wherein a user switches between various conversion modes of the pulse conversion module (12) via the two buttons (16), and
wherein the display (15) at least displays a conversion mode which is currently implemented by the pulse conversion module (12), and the display (15) is a 1-bit digital display displaying at least the numbers 0 to 8, and each number displayed corresponds to one conversion mode, wherein the nine numbers 0 to 8 represent all the conversion modes between every two of the three control types, and wherein the two buttons (16) respectively realize the operations of adding one to and subtracting one from a number on the 1-bit digital display when being pressed down, so as to switch the conversion mode by means of either of the two buttons (16).

2. The servo driver (10) of claim 1, wherein the pulse conversion module (12) further comprises a first transceiver (17) and a second transceiver (18) which are in signal connection with the complex programmable logic device (14), wherein the first transceiver (17) is in signal connection with the driver (11), and the second transceiver (18) is in signal connection with the pulse interface (13).

## Patentansprüche

1. Servotreiber (10), umfassend:
einen Treiber (11),
ein Impulsumwandlungsmodul (12) und
eine Impulsschnittstelle (13),
wobei das Impulsumwandlungsmodul (12) zwischen die Impulsschnittstelle (13) und den Treiber (11) geschaltet ist und das Impulsumwandlungsmodul (12) den Typ eines durch die Impulsschnittstelle (13) empfangenen Impulssteuersignals umwandelt und dieses anschließend an den Treiber (11) ausgibt, wobei der Typ des Impulssteuersignals mindestens eines von einem Impulssteuerungstyp im Uhrzeigersinn und gegen den Uhrzeigersinn, einem Impuls-plus-Richtung-Steuerungstyp und einem AB-Phaseneingangs-Steuerungstyp umfasst,
wobei das Impulsumwandlungsmodul (12) eine komplexe programmierbare Logikvorrichtung (14) umfasst und in der komplexen programmierbaren Logikvorrichtung (14) eine Impulsumwandlungslogik zur Realisierung der Umwandlung zwischen verschiedenen Impulssteuersystem-Signaltypen bereitgestellt ist und wobei die komplexe programmierbare Logikvorrichtung für parallele Verarbeitung konfiguriert ist, und
wobei das Impulsumwandlungsmodul (12) eine Anzeige (15) und zwei Tasten (16) umfasst, die mit der komplexen programmierbaren Logikvorrichtung (14) in Signalverbindung stehen, wobei das Impulsumwandlungsmodul (12) eine separate Vorrichtung ist, die an einem Gehäuse des Servotreibers (10) so bereitgestellt ist, dass die Anzeige (16) und die beiden Tasten (16) freiliegen,
wobei ein Benutzer über die beiden Tasten (16) zwischen verschiedenen Umwandlungsmodi des Impulsumwandlungsmoduls (12) umschaltet und
wobei die Anzeige (15) zumindest einen Umwandlungsmodus anzeigt, der aktuell vom Impulsumwandlungsmodul (12) implementiert wird, und die Anzeige (15) eine 1-Bit-Digitalanzeige ist, die zumindest die Ziffern 0 bis 8 anzeigt, und jede angezeigte Ziffer einem Umwandlungsmodus entspricht, wobei die neun Ziffern 0 bis 8 alle Umwandlungsmodi zwischen jeweils zwei der drei Steuerungstypen darstellen und wobei die beiden Tasten (16) bei Betätigung jeweils die Operationen "Addieren von eins" zu und "Subtrahieren von eins" von einer Ziffer auf der 1-Bit-Digitalanzeige realisieren, um den Umwandlungsmodus mittels einer der beiden Tasten (16) umzuschalten.

2. Servotreiber (10) nach Anspruch 1, wobei das Impulsumwandlungsmodul (12) ferner einen ersten Sendeempfänger (17) und einen zweiten Sendeempfänger (18) umfasst, die mit der komplexen programmierbaren Logikvorrichtung (14) in Signalverbindung stehen, wobei der erste Sendeempfänger (17) mit dem Treiber (11) in Signalverbindung steht und der zweite Sendeempfänger (18) mit der Impulsschnittstelle (13) in Signalverbindung steht.

## Revendications

1. Servovariateur (10) comprenant :
un pilote (11),
un module de conversion d'impulsions (12) et
une interface d'impulsion (13) ;
dans lequel le module de conversion d'impulsions (12) est connecté entre l'interface d'impulsion (13) et le pilote (11), et le module de conversion d'impulsions (12) convertit le type d'un signal de commande par impulsions reçu par l'interface d'impulsion (13) puis le sort vers le pilote (11), le type du signal de commande par impulsions comprenant au moins un parmi un type de commande par impulsions sens horaire et sens antihoraire, un type de commande par impulsions plus direction et un type de commande à entrée de phases A/B,
dans lequel le module de conversion d'impulsions (12) comprend un dispositif logique programmable complexe (14), et une logique de conversion d'impulsions pour réaliser la conversion entre différents types de signaux de système de commande par impulsions est fournie dans le dispositif logique programmable complexe (14) et dans lequel le dispositif logique programmable complexe est configuré pour un traitement parallèle, et
dans lequel le module de conversion d'impulsions (12) comporte un afficheur (15) et deux boutons (16) qui sont en liaison signal avec le dispositif logique programmable complexe (14), dans lequel le module de conversion d'impulsions (12) est un dispositif séparé fourni sur un boîtier du servovariateur (10) de manière à exposer l'afficheur (16) et les deux boutons (16), dans lequel un utilisateur bascule entre différents modes de conversion du module de conversion d'impulsions (12) par le biais des deux boutons (16), et
dans lequel l'afficheur (15) affiche au moins un mode de conversion qui est actuellement mis en œuvre par le module de conversion d'impulsions (12), et l'afficheur (15) est un afficheur numérique à 1 bit affichant au moins les nombres 0 à 8, et chaque nombre affiché correspond à un mode de conversion, les neuf nombres 0 à 8 représentant tous les modes de conversion entre deux types de commande quelconques parmi les trois, et dans lequel les deux boutons (16) réalisant respectivement les opérations d'ajout d'un à un nombre sur l'afficheur numérique à 1 bit, et de soustraction d'un à partir de celui-ci, lorsqu'ils sont enfoncés, de manière à changer de mode de conversion au moyen de l'un ou l'autre des deux boutons (16).

2. Servovariateur (10) selon la revendication 1, dans lequel le module de conversion d'impulsions (12) comprend en outre un premier émetteur-récepteur (17) et un second émetteur-récepteur (18) qui sont en liaison signal avec le dispositif logique programmable complexe (14), dans lequel le premier émetteur-récepteur (17) est en liaison signal avec le pilote (11), et le second émetteur-récepteur (18) est en liaison signal avec l'interface d'impulsion (13).
